# EUROPEAN PATENT APPLICATION

(11) **EP 4 534 943 A1**
(43) Date of publication of application: **09.04.2025**
(21) Application number: 23811087.8
(22) Date of filing: 24.05.2023
(51) Int. Cl.: F28F 3/02, H05K 7/20, F24F 1/24

(54) **FIN ASSEMBLY AND EVAPORATOR THEREOF**

(30) Priority: 26.05.2022 CN 202221292575 U
(71) Applicant: Guangdong Envicool Technology Co., Ltd., Sanjiao Town, Zhongshan Guangdong 528400 (CN)
(72) Inventor: TU, Yijian, Zhongshan, Guangdong 528400 (CN); HE, Zhiming, Zhongshan, Guangdong 528400 (CN)
(74) Representative: Potter Clarkson
(86) International application number: PCT/CN2023/095985
(87) International publication number: WO 2023/227017

(57) **Abstract**

A fin assembly and an evaporator thereof. The fin assembly comprises a fin assembly. The fin assembly comprises at least one first fin and at least one second fin, and the first fin and the second fin are stacked; the first fin comprises a first toothholder and a plurality of first tooth blades, and the plurality of first tooth blades are arranged at intervals in a length direction of the first toothholder; the second fin comprises a second toothholder and a plurality of second tooth blades, and the plurality of second tooth blades are arranged at intervals in a length direction of the second toothholder; the first tooth blades and the second tooth blades are provided in a staggered manner, so that staggered fluid channels are formed between the first fin and the second fin. The fin assembly in the present application can solve the problem that heat exchange efficiency of heat dissipation structures of existing heat dissipation devices is low.

## Description

The present application claims priority to Chinese Patent Application No. 202221292575.1, titled "FIN ASSEMBLY AND EVAPORATOR HAVING THE SAME", filed with the China National Intellectual Property Administration on May 26, 2022, which is incorporated herein by reference in its entirety.

### FIELD

The present application relates to the technical field of heat dissipation, and in particular to a fin assembly and an evaporator having the same.

### BACKGROUND

At present, the power consumption of electronic devices such as a system server is increased, and if there is no heat dissipation design, the electronic devices may easily break down or even get burned. Therefore, a heat dissipation product is provided on the electronic devices.

The heat dissipation product in the conventional technology has evolved from a conventional air-cooling module to a siphon radiator. However, a heat dissipation structure of an evaporator of a conventional siphon radiator has low heat exchange efficiency, which cannot meet requirements of a high-power-consumption electronic device.

### SUMMARY

A fin assembly and an evaporator having the same are provided according to the present application, so as to solve the problem of low heat exchange efficiency of a heat dissipation structure of a conventional radiator.

According to a first aspect of the present application, a fin assembly includes at least one first fin and at least one second fin, where the at least one first fin and the at least one second fin are arranged in a stacked manner;
each of the at least one first fin includes a first tooth seat and a plurality of first teeth, the plurality of first teeth are spaced apart along a length direction of the first tooth seat;
each of the at least one second fin includes a second tooth seat and a plurality of second teeth, and the plurality of second teeth are spaced apart along a length direction of the second tooth seat; and
the plurality of first teeth and the plurality of second teeth are arranged in a staggered manner, so that staggered fluid channels are formed between the at least one first fin and the at least one second fin.

In an embodiment, a first gap is formed between two adjacent first teeth, a second gap is formed between two adjacent second teeth, and the first gap and the second gap are arranged in a staggered manner.

In an embodiment, each of the plurality of first teeth is arranged to confront the corresponding second gap, and each of the plurality of second teeth is arranged to confront the corresponding first gap, so that staggered fluid channels are formed between the at least one first fin and the at least one second fin.

In an embodiment, a width of each of the plurality of first teeth is less than a width of the second gap, and a width of each of the plurality of second teeth is less than a width of the first gap.

In an embodiment, the fluid channel is formed between the first tooth and the second tooth which are adjacent to each other.

In an embodiment, the width of the first tooth is equal to the width of the second tooth; and the width of the first gap is equal to the width of the second gap.

In an embodiment, a first punching point is provided on the first tooth seat; and a second punching point that matches the first punching point is provided on the second tooth seat.

In an embodiment, the number of the first punching points is three, two of the three first punching points are respectively located at two ends of the first tooth seat, and one of the three first punching points is located in the middle of the first tooth seat; and the number of the second punching points are three, two of the three second punching points are located at two ends of the second tooth seat, and one of the three second punching points is located in the middle of the second tooth seat.

In an embodiment, the at least one first fin and the at least one second fin are flexible fins.

According to a second aspect of the present application, an evaporator includes:
the fin assembly described above; and
a bottom plate, wherein the bottom plate comprises a first side and a second side, the first side is configured to contact a heat source, and the fin assembly is mounted on the second side.

The beneficial effects of the present application at least include:
According to the fin assembly of the present application, the first teeth and the second teeth are arranged in a staggered manner, so that waste heat can diffuse outward along a height direction of the first tooth seat, and local heat exchange can occur in the staggered fluid channels. In the fin assembly, the first fin and the second fin are arranged in a stacked manner, and the first teeth and the second teeth are arranged in a staggered manner, so that a heat-exchange surface area of a working medium is increased, which improves the ability to absorb the waste heat. When power of a heat source is increased, the working medium boils to generate bubbles, and the bubbles then contact a surface of the fin to perform phase-change heat exchange, so that an electronic equipment product can perform phase-change heat exchange in a high-power-consumption environment.

### BRIEF DESCRIPTION OF THE DRAWINGS

FIG. 1 is a schematic diagram of the installation of a common fin structure on a bottom plate in the conventional technology;
FIG. 2 is a schematic diagram of the installation of a skiving-formed structure on a bottom plate in the conventional technology;
FIG. 3 is a schematic diagram of the installation of a fin assembly on a bottom plate in the present application;
FIG. 4 is an enlarged view of portion A in Figure 3;
FIG. 5 is a partial exploded view of a first fin and a second fin in a fin assembly according to the present application;
FIG. 6 is a schematic structural diagram of a first fin in a fin assembly according to the present application;
FIG. 7 is a schematic structural diagram of a second fin in a fin assembly according to the present application; and
FIG. 8 is a schematic structural diagram of a fin assembly according to an embodiment of the present application.

Reference numerals are listed as follows:
1 fin assembly;
   11 first fin;
      111 first tooth seat;
         1111 first punching point;
      112 first tooth;
         1120 first gap;
   12 second fin;
      121 second tooth seat;
         1211 second punching point;
      122 second tooth;
         1220 second gap;
   13 flat plate;
2, 2' bottom plate;
   201 first side;
   202 second side;
3 common fin structure;
4 skiving-formed structure.

The drawings herein are incorporated into the specification and constitute a part of the specification. The drawings show embodiments of the present application. The drawings and the specification are used to explain the principle of the present application.

### DETAILED DESCRIPTION OF EMBODIMENTS

In order to better understand the technical solutions of the present application, the embodiments of the present application are described in detail below with reference to the accompanying drawings.

It is apparent that the described embodiments are only a part of the embodiments of the present application, rather than all of the embodiments. Any other embodiments obtained by those skilled in the art based on the embodiments in the present application without any creative effort shall fall within the protection scope of the present application.

The terminology used in the present application is only for purpose of describing the specific embodiments, and is not intended to limit the present application. The terms "a/an", "the said", and "the" in a singular form used in the embodiments and appended claims of the present application are intended to include a plural form, unless other meanings are clearly indicated in the context.

It should be understood that the term "and/or" used in the present application is only an association relationship to describe the associated objects, indicating that there may be three kinds of relationships, for example, A and/or B may indicate three cases, such as A exists alone, A and B exist at the same time, and B exists alone. In addition, the character "/" in this specification indicates that the associated objects before and after the character "/" are in an "or" relationship.

It should be noted that the directional words such as "up", "down", "left", and "right" in the embodiments of the present application are described based on the perspective angle shown in the drawings, and should not be construed as limitation on the embodiments of the present application. In addition, it should also be understood that when an element is referred to as being connected "on" or "under" another element, it means that the element may be directly connected "on" or "under" the another element, or may also be indirectly connected "on" or "under" the another element by an intermediate element.

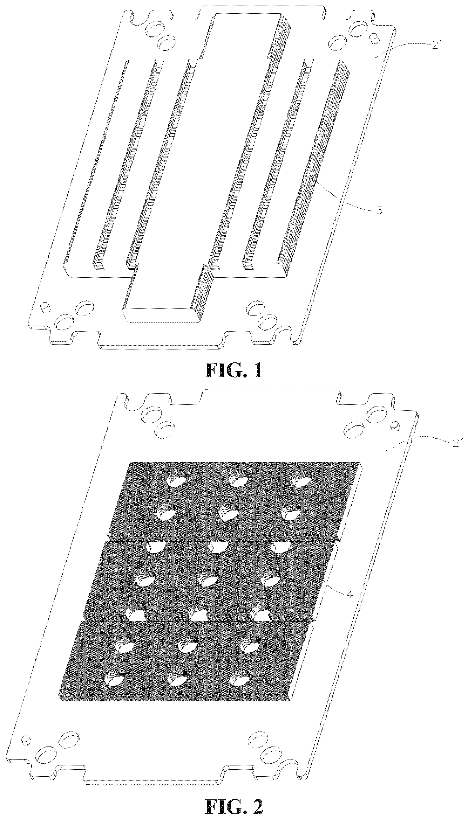

A heat dissipation structure for an evaporator of a radiator of a conventional electronic device such as a server mainly includes a common fin structure and a skiving-formed structure. As shown in FIG. 1, a common fin structure 3 is welded on a bottom plate 2' of an evaporator, a distance between fins is large, an area of a surface in contact with liquid is small, and the heat exchange efficiency is low, which cannot meet requirements of a high-power-consumption electronic device. As shown in FIG. 2, a skiving-formed structure 4 is welded on a bottom plate 2' of an evaporator. The disadvantage of the evaporator with this structure is that it is difficult to process a flow channel structure meeting requirements of a product by skiving, the process is complex, the mass production thereof is unpractical, and the mass production price thereof is expensive.

Regarding the problems of low heat exchange efficiency, complex process, and high cost of the heat dissipation structure of the conventional evaporator, a fin assembly is provided according to the embodiments of the present application. The fin assembly can be applied to an evaporator of a radiator for heat dissipation of electronic equipment, which includes but is not limited to a server.

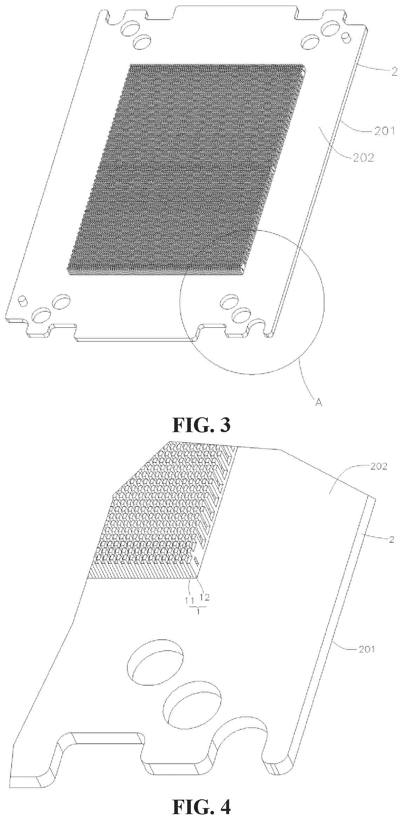

An evaporator is provided according to the embodiments of the present application. As shown in FIGS. 3 and 4, the evaporator includes a fin assembly 1 and a bottom plate 2. The bottom plate 2 includes a first side 201 and a second side 202. The first side 201 is configured to contact a heat source, and the fin assembly 1 is mounted on the second side 202.

A fin assembly is provided according to the embodiments of the present application. As shown in FIGS. 3 to 5, the fin assembly 1 includes at least one first fin 11 and at least one second fin 12. The first fin 11 and the second fin 12 are arranged in a stacked manner.

The first fin 11 includes a first tooth seat 111 and multiple first teeth 112. The multiple first teeth 112 are spaced apart along a length direction of the first tooth seat 111. The second fin 12 includes a second tooth seat 121 and multiple second teeth 122. The multiple second teeth 122 are spaced apart along a length direction of the second tooth seat 121.

The multiple first teeth 112 and the multiple second teeth 122 are arranged in a staggered manner, so that staggered fluid channels are formed between the first fin 11 and the second fin 12.

The fin assembly 1 of the present embodiment includes at least one first fin 11 and at least one second fin 12. The first fin 11 and the second fin 12 are alternately connected, and the connection method may be a punching connection, so that the production cost can be greatly reduced. The first fin 11 includes a first tooth seat 111 and multiple first teeth 112. A longitudinal section of each first tooth 112 may be rectangular, square, trapezoidal, triangular, wavy and so on. In some specific embodiments, the longitudinal section of each first tooth 112 is rectangular, and the multiple first teeth 112 are spaced apart along the length direction of the first tooth seat 111. When the fin assembly 1 is mounted on the second side 202 of the bottom plate 2, an end of the first tooth seat 111 facing away from the first tooth 112 is connected to the bottom plate 2. The second fin 12 includes a second tooth seat 121 and multiple second teeth 122. A longitudinal section of each second tooth 122 may be rectangular, square, trapezoidal, triangular, wavy and so on. In some specific embodiments, the longitudinal section of each second tooth 122 is rectangular, and the multiple second teeth 122 are spaced apart along the length direction of the second tooth seat 121. When the fin assembly 1 is mounted on the second side 202 of the bottom plate 2, an end of the second tooth seat 121 facing away from the second tooth 122 is connected to the bottom plate 2. The first teeth 112 and the second teeth 122 are arranged in a staggered manner, so that staggered fluid channels are formed between the first fin 11 and the second fin 12. The first teeth 112 and the second teeth 122 are arranged in a staggered manner, so that waste heat can diffuse outward along a height direction of the first tooth seat 111, and local heat exchange can occur in the staggered fluid channels. In the fin assembly 1, the at least one first fin 11 and the at least one second fin 12 are arranged in a stacked manner, and the first teeth 112 and the second teeth 122 are arranged in a staggered manner, so that a heat-exchange surface area of a working medium is increased, which improves the ability to absorb the waste heat. When power of the heat source is increased, the working medium boils to generate bubbles, and the bubbles then contact a surface of the fin to perform phase-change heat exchange, so that an electronic equipment product can perform phase-change heat exchange in a high-power-consumption environment, making the Q value of the product reach a higher range. In addition, the structure of the fin assembly according to the present embodiments is simple, the manufacturing process thereof is simple, and parameters such as the size of the first tooth 112 and the second tooth 122 can be adjusted according to actual needs, so that there are more choices for components, different effectiveness data can be obtained, and thus the overall effectiveness of the product is improved.

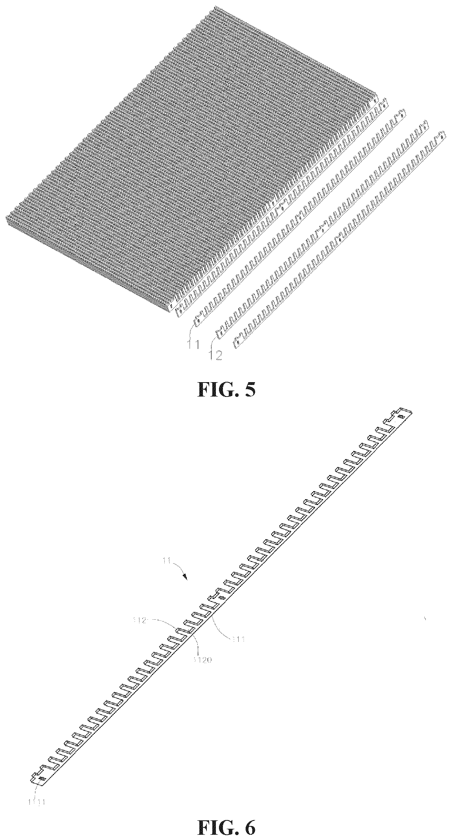

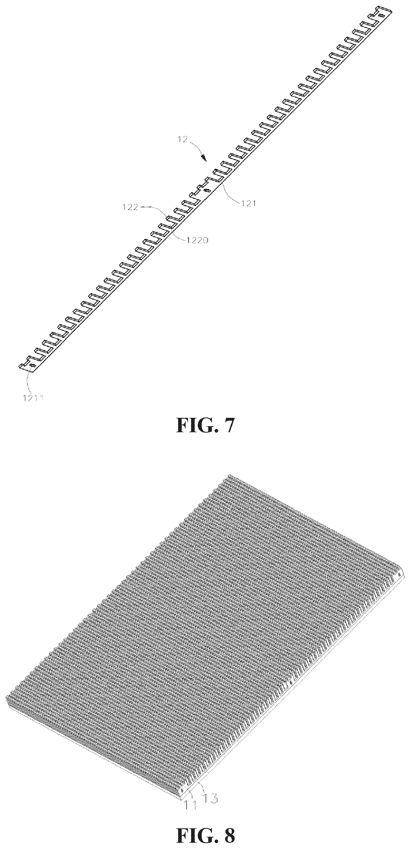

In some embodiments, as shown in FIG. 6, a first gap 1120 is formed between two adjacent first teeth 112, and as shown in FIG. 7, a second gap 1220 is formed between two adjacent second teeth 122. The first gap 1120 and the second gap 1220 are arranged in a staggered manner.

In the present embodiment, the first gap 1120 is formed between two adjacent first teeth 112, the second gap 1220 is formed between two adjacent second teeth 122, and it is defined that the first gap 1120 and the second gap 1220 are arranged in a staggered manner, so that staggered paths of the fluid channels are more complicated, which further increases the heat-exchange surface area of the working medium and improves the ability to absorb waste heat.

In some embodiments, each first tooth 112 is arranged to confront the corresponding second gap 1220, and each second tooth 122 is arranged to confront the corresponding first gap 1120, so that staggered fluid channels are formed between the first fin 11 and the second fin 12.

In the present embodiment, each first tooth 112 is arranged to confront the corresponding second gap 1220, and each second tooth 122 is arranged to confront the corresponding first gap 1120, so that staggered paths of the fluid channels are more complicated, which further increases the heat-exchange surface area of the working medium and improves the ability to absorb waste heat.

In some embodiments, a width of each first tooth 112 is less than a width of the second gap 1220, and a width of each second tooth 122 is less than a width of the first gap 1120.

In the present embodiment, the width of each first tooth 112 is defined to be less than the width of the second gap 1220, and the width of each second tooth 122 is defined to be less than the width of the first gap 1120, so that liquid can bypass the first tooth 112 and the second tooth 122 from two ends of the first tooth 112 and two ends of the second tooth 122 to enter the second gap 1220 and the first gap 1120 when the liquid flows in the staggered fluid channels, which can further increase the heat-exchange surface area of the working medium and improve the ability to absorb waste heat.

In some embodiments, the width of each first tooth 112 is equal to the width of each second tooth 122; and the width of the first gap 1120 is equal to the width of the second gap 1220. The fluid channel is formed between the first tooth 112 and the second tooth 122 which are adjacent to each other.

In the present embodiment, the width of each first tooth 112 is defined to be equal to the width of each second tooth 122, and the width of the first gap 1120 is defined to be equal to the width of the second gap 1220, which can ensure that sizes of the staggered fluid channels are uniform at different staggered positions, thereby ensuring uniform flow velocity of the liquid in the staggered fluid channels and improving heat exchange efficiency.

In some embodiments, one or more first punching points 1111 are provided on the first tooth seat 111; and one or more second punching points 1211 that match the one or more first punching points 1111 are provided on the second tooth seat 121.

In the present embodiment, by arranging the one or more first punching points 1111 on the first tooth seat 111 and arranging the one or more second punching points 1211 that match the one or more first punching points 1111 on the second tooth seat 121, punching forming between the first fin 11 and the second fin 12 can be achieved, which can greatly reduce the production cost and improve the production efficiency.

In some embodiments, the number of the first punching points 1111 is three, two of the three first punching points 1111 are respectively located at two ends of the first tooth seat 111, and one of the three first punching points 1111 is located in the middle of the first tooth seat 111; and the number of the second punching points 1211 are three, two of the three second punching points 1211 are located at two ends of the second tooth seat 121, and one of the three second punching points 1211 is located in the middle of the second tooth seat 121.

In the present embodiment, the number of the first punching points 1111 and the number of the second punching points 1211 are both defined as three, and the three first punching points 1111 are respectively arranged at the two ends and the middle of the first tooth seat 111, and the three second punching points 1211 are respectively arranged at the two ends and the middle of the second tooth seat 121, which can ensure the stability of the punch-formed structure of the first fin 11 and the second fin 12, and improve the structural strength of the fin assembly 1, thereby prolonging the service life of the heat dissipation structure.

In some embodiments, the first fin 11 and the second fin 12 are flexible fins.

In the present embodiment, the first fin 11 and the second fin 12 are designed as flexible fins, so that the fins can fold at will to form a capillary structure, thereby reducing thermal resistance by increasing capillary force and improving the heat exchange efficiency.

In some embodiments, as shown in FIG. 8, the fin assembly 1 further includes a flat plate 13, one side of the flat plate 13 is connected to an end of the first tooth seat 111, and the other side of the flat plate 13 is connected to the bottom plate 2.

In the present embodiment, the fin assembly 1 further includes the flat plate 13. During installation, one side of the flat plate 13 is connected to an end of the first tooth seat 111, and the other side of the flat plate 13 may be welded to the second side 202 of the bottom plate 2 by tin soldering or aluminum soldering, so that the fin assembly 1 can be mounted on the bottom plate 2 more stably.

In some embodiments, each of the first fin 11 and the second fin 12 has a rough surface.

In the present embodiment, the first fin 11 and the second fin 12 may be individually processed by sand blasting, wire drawing, and polishing to form a rough surface and increase the surface roughness thereof. As a result, the heat exchange areas are increased, thereby improving the heat exchange efficiency.

The above embodiments are preferred embodiments of the present application, which are not intended to limit the present application, and those skilled in the art can make various modifications and variations to the present application. Any modifications, equivalent replacements and improvements made within the principle of the present application shall be within the protection scope of the present application.

## Claims

1. A fin assembly, comprising at least one first fin and at least one second fin, wherein the at least one first fin and the at least one second fin are arranged in a stacked manner;
each of the at least one first fin comprises a first tooth seat and a plurality of first teeth, the plurality of first teeth are spaced apart along a length direction of the first tooth seat;
each of the at least one second fin comprises a second tooth seat and a plurality of second teeth, and the plurality of second teeth are spaced apart along a length direction of the second tooth seat; and
the plurality of first teeth and the plurality of second teeth are arranged in a staggered manner, so that staggered fluid channels are formed between the at least one first fin and the at least one second fin.

2. The fin assembly according to claim 1, wherein a first gap is formed between two adjacent first teeth, a second gap is formed between two adjacent second teeth, and the first gap and the second gap are arranged in a staggered manner.

3. The fin assembly according to claim 2, wherein each of the plurality of first teeth is arranged to confront the corresponding second gap, and each of the plurality of second teeth is arranged to confront the corresponding first gap, so that staggered fluid channels are formed between the at least one first fin and the at least one second fin.

4. The fin assembly according to claim 2, wherein a width of each of the plurality of first teeth is less than a width of the second gap, and a width of each of the plurality of second teeth is less than a width of the first gap.

5. The fin assembly according to claim 4, wherein the fluid channel is formed between the first tooth and the second tooth which are adjacent to each other.

6. The fin assembly according to claim 4, wherein the width of the first tooth is equal to the width of the second tooth; and the width of the first gap is equal to the width of the second gap.

7. The fin assembly according to claim 1, wherein a first punching point is provided on the first tooth seat; and a second punching point that matches the first punching point is provided on the second tooth seat.

8. The fin assembly according to claim 7, wherein the number of the first punching points is three, two of the three first punching points are respectively located at two ends of the first tooth seat, and one of the three first punching points is located in the middle of the first tooth seat; and
the number of the second punching points are three, two of the three second punching points are located at two ends of the second tooth seat, and one of the three second punching points is located in the middle of the second tooth seat.

9. The fin assembly according to claim 1, wherein the at least one first fin and the at least one second fin are flexible fins.

10. An evaporator, comprising:
the fin assembly according to any one of claims 1 to 9;
a bottom plate, wherein the bottom plate comprises a first side and a second side, the first side is configured to contact a heat source, and the fin assembly is mounted on the second side.
